# EUROPEAN PATENT APPLICATION

(11) **EP 2 523 337 A2**
(43) Date of publication of application: **14.11.2012**
(21) Application number: 12167744.7
(22) Date of filing: 11.05.2012
(51) Int. Cl.: H02M 7/04

(54) **Apparatus for detecting input phase missing and method thereof**

(30) Priority: 13.05.2011 KR 20110045310
(71) Applicant: LSIS Co., Ltd., Dongan-gu, Anyang-si Gyeonggi-do 431-080 (KR)
(72) Inventor: LEE, Eun Woo, 430-040 GYEONGGI-DO (KR)
(74) Representative: Löfgren, Håkan Bengt Alpo

(57) **Abstract**

Provided is an apparatus for detecting input phase missing and a method thereof, wherein the apparatus includes: a power input unit applying a 3-phase AC voltage; a rectifying unit rectifying the AC voltage applied from the power input unit; a filter unit bandpass-filtering the rectified voltage and calculating magnitude of ripple voltage from the filtered voltage; and a missing input phase detecting unit determining whether an input phase missing has occurred according to the magnitude of the ripple voltage, whereby the input phase missing can be detected without an error, and a method thereof, and fast response and simplicity of embodiment can be realized without calculation process of ripple frequency.

## Description

### BACKGROUND OF THE DISCLOSURE

### Field of the invention

The present disclosure relates to an apparatus for detecting input phase missing and a method thereof, and more particularly to an apparatus for detecting input phase missing, configured to determine magnitude of ripple voltage inputted to a 3-phase inverter to detect whether there is a missed input phase, and a method thereof.

### Background

An inverter can be used for various purposes. One example is a 3-phase inverter for driving an induction motor or a synchronous motor in accelerated speed or a changed speed. The 3-phase motor receives a 3-phase AC power and obtains a DC power through a diode rectifier.

Meanwhile, the 3-phase inverter is formed with a smoothing capacitor to maintain a DC power voltage close to a DC current. The smoothing capacitor is usually used with an aluminum electrolytic capacitor, where life of the aluminum electrolytic capacitor is related to a ripple current of the capacitor. The ripple current generates heat inside the capacitor to shorten the life. The life of capacitor is determined by a life of an inverter, because the life of electrolytic capacitor is shorter than that of semi-permanent switching element or other parts of an inverter.

In a case a power of one phase in a 3-phase input fails to be supplied due to short-circuit or the like, a ripple current flowing in the capacitor problematically increases in size to shorten a life of a capacitor. Thus, attempts have been made to detect a missing input phase.

A conventional method for detecting a missing input phase was largely a method for determining whether there is a missing input phase, using a minimum value of DC voltage. That is, a DC voltage is changed depending on load situation, where a minimum value of DC voltage is reduced when there are lots of loads over a case when there is no load. The minimum value of DC voltage is greatly reduced when there is a missing input phase, and the conventional method detects the missing input phase using this technique.

However, the conventional method is disadvantageous in that an error is generated in the course of detecting the missing input phase.

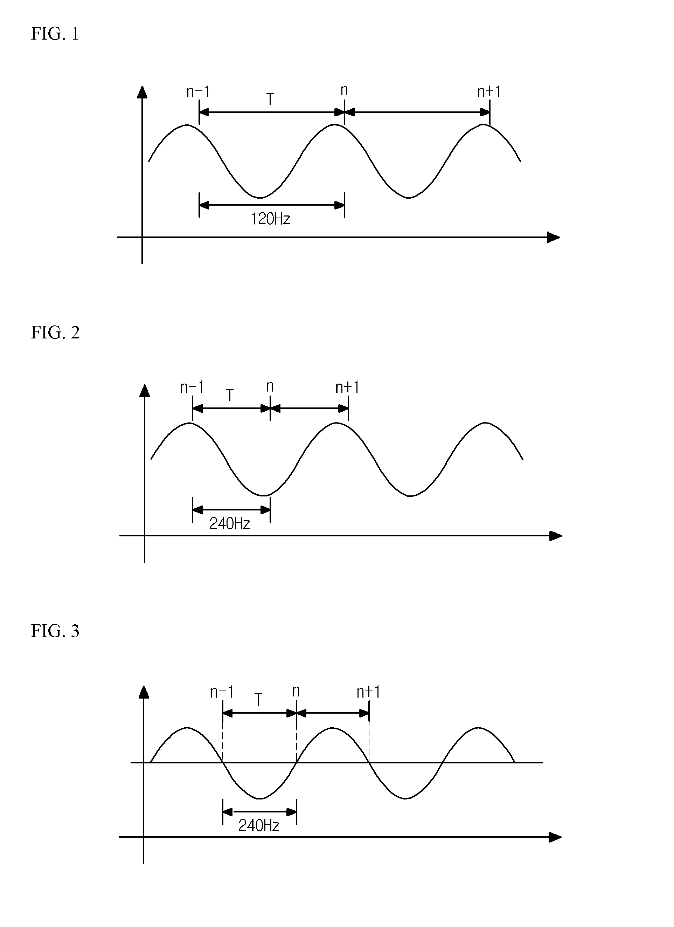

FIGS. 1, 2 and 3 illustrate methods for detecting the missing input phase according to prior art. Referring to FIGS. 1, 2 and 3, a voltage across a filter capacitor was measured, and the measured voltage was sampled in an integer of a ripple voltage cycle.

FIG.1 illustrates that the ripple voltage cycle is represented in 120Hz, which is twice the input power frequency of 60Hz, and also illustrates one time sampling of 120Hz. In case of sampling in the same cycle as that of ripple voltage cycle, it is difficult to know a range of fluctuation in ripples, because a same value is being read for each cycle.

FIG.2 illustrates a method of sampling twice the ripple voltage cycle, where amplitude of ripple voltage can be known if sampled at a time where a maximum value and a minimum value of ripple voltage are sampled. However, there is no clear mention how to know the time the maximum value and the minimum value were generated. If sampled at an arbitrary time, there occurs a problem of failing to know the amplitude.

Meanwhile, in case of sampling as shown in FIG.3, there is a problem of V₁(n+1)-V₁(n)=0 while the ripples are present.

The aforementioned conventional techniques can generate an error of input phase missing, and it is difficult to solve the problem.

### SUMMARY

The present disclosure has been made to solve the foregoing problems of the prior art, and therefore an object of certain embodiments of the present invention is to provide an apparatus configured to detect an input phase missing without an error, and a method thereof.

Another object is to provide an apparatus for detecting an input phase missing, configured to realize a fast response and simplicity of embodiment without calculation process of ripple frequency, and a method thereof.

In one general aspect of the present disclosure, there is provided an apparatus for detecting an input phase missing based on a voltage inputted to a 3-phase inverter, the apparatus comprising: a power input unit applying a 3-phase AC voltage; a rectifying unit rectifying the AC voltage applied from the power input unit; a filter unit bandpass-filtering the rectified voltage and calculating magnitude of ripple voltage from the filtered voltage; and a missing input phase detecting unit determining whether an input phase missing has occurred according to the magnitude of the ripple voltage.

Preferably, but not necessarily, the filter unit includes a band-pass filter extracting a predetermined frequency band from the DC voltage, and an RMS (Root Mean Square) calculation unit converting the frequency band extracted from the band-pass filter to a value.

Preferably, but not necessarily, the band-pass filter extracts a frequency component from 110Hz to 130Hz, in a case a commercial power source of 60Hz is used.

Preferably, but not necessarily, a sampling frequency of the band-pass filter is at least 240Hz, in a case a commercial power source of 60Hz is used.

Preferably, but not necessarily, the apparatus further comprises a display unit for displaying whether an input phase missing has occurred.

In another general aspect of the present disclosure, there is provided a method for detecting an input phase missing based on a voltage inputted to a 3-phase inverter, the method comprising: applying a 3-phase AC voltage; rectifying the AC voltage; bandpass-filtering the rectified voltage; and calculating magnitude of ripple voltage from the filtered voltage, and determining that an input phase missing has occurred according to the magnitude of the ripple voltage.

Preferably, but not necessarily, the filtering step includes extracting a predetermined frequency band from the rectified voltage, and converting the magnitude of the extracted frequency band to a RMS (Root Mean Square) value.

Preferably, but not necessarily, the method further comprises displaying whether an input phase missing has occurred.

Preferably, but not necessarily, discontinuing operation of a PWM (Pulse Width Modulation) inverter operating a motor, in a case it is determined by the determining step that the input phase missing has occurred.

The apparatus for detecting input phase missing and the method thereof according to the present disclosure has an advantageous effect in that an input phase missing can be detected without an error, and a fast response and simplicity of embodiment can be realized without calculation process of ripple frequency.

### BRIEF DESCRIPTION OF THE DRAWINGS

The drawing figures depict one or more exemplary embodiments in accord with the present concepts, by way of example only, not by way of limitations. In the figures, like reference numerals refer to the same or similar elements.

Thus, a wide variety of potential practical and useful embodiments will be more readily understood through the following detailed description of certain exemplary embodiments, with reference to the accompanying exemplary drawings in which:
FIGS. 1, 2 and 3 illustrate methods for detecting the missing input phase according to prior art;
FIG. 4 is a schematic block diagram illustrating a configuration of an apparatus for detecting input phase missing according to an exemplary embodiment of the present disclosure;
FIG.5 is a circuit diagram illustrating an apparatus for detecting input phase missing according to an exemplary embodiment of the present disclosure;
FIG.6 is a schematic view illustrating a problem unsolved by prior art;
FIG.7 is a schematic view illustrating an effect of an apparatus for detecting input phase missing according to an exemplary embodiment of the present disclosure;
FIGS. 8 and 9 are schematic views illustrating a method for detecting an input phase missing by processing a DC voltage, by an apparatus for detecting input phase missing according to an exemplary embodiment of the present disclosure;
FIGS.10a and 10b are schematic views illustrating a variety of examples applicable by an apparatus for detecting input phase missing according to an exemplary embodiment of the present disclosure; and
FIG.11 is a flowchart illustrating a method for detecting an input phase missing according to an exemplary embodiment of the present disclosure.

### DETAILED DESCRIPTION

The disclosed embodiments and advantages thereof are best understood by referring to FIGS. 1-11 of the drawings, like numerals being used for like and corresponding parts of the various drawings. Other features and advantages of the disclosed embodiments will be or will become apparent to one of ordinary skill in the art upon examination of the following figures and detailed description. It is intended that all such additional features and advantages be included within the scope of the disclosed embodiments, and protected by the accompanying drawings. Further, the illustrated figures are only exemplary and not intended to assert or imply any limitation with regard to the environment, architecture, or process in which different embodiments may be implemented. Accordingly, the described aspect is intended to embrace all such alterations, modifications, and variations that fall within the scope and novel idea of the present invention.

Meanwhile, the terminology used herein is for the purpose of describing particular implementations only and is not intended to be limiting of the present disclosure. The terms "first," "second," and the like, herein do not denote any order, quantity, or importance, but rather are used to distinguish one element from another. For example, a second constituent element may be denoted as a first constituent element without departing from the scope and spirit of the present disclosure, and similarly, a first constituent element may be denoted as a second constituent element.

As used herein, the terms "a" and "an" herein do not denote a limitation of quantity, but rather denote the presence of at least one of the referenced item. That is, as used herein, the singular forms "a", "an" and "the" are intended to include the plural forms as well, unless the context clearly indicates otherwise.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Also, "exemplary" is merely meant to mean an example, rather than the best. If is also to be appreciated that features, layers and/or elements depicted herein are illustrated with particular dimensions and/or orientations relative to one another for purposes of simplicity and ease of understanding, and that the actual dimensions and/or orientations may differ substantially from that illustrated.

That is, in the drawings, the size and relative sizes of layers, regions and/or other elements may be exaggerated or reduced for clarity. Like numbers refer to like elements throughout and explanations that duplicate one another will be omitted. As may be used herein, the terms "substantially" and "approximately" provide an industry-accepted tolerance for its corresponding term and/or relativity between items.

Hereinafter, the present disclosure will be described in detail with reference to the accompanying drawings.

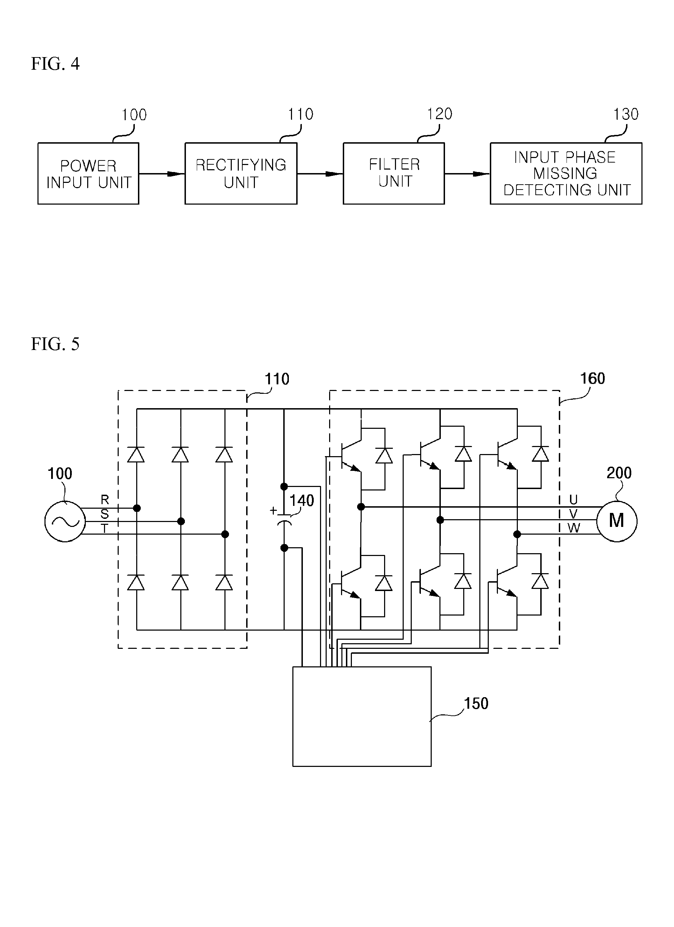

FIG. 4 is a schematic block diagram illustrating a configuration of an apparatus for detecting input phase missing according to an exemplary embodiment of the present disclosure.

Referring to FIG.4, an apparatus for detecting input phase missing according to an exemplary embodiment of the present disclosure includes a power input unit 100, a rectifying unit 110, a filter unit 120 and an input phase missing detecting unit 130.

The power input unit 100 functions to input a 3-phase AC voltage. The rectifying unit 110 includes a plurality of diodes, and functions to rectify each of the 3-phase AC voltages (R, S, T) inputted from the power input unit 100. In other words, the rectifying unit 110 outputs the rectified voltage or the rectified signal.

The filter unit 120 functions to separate a predetermined frequency band from the rectified voltage rectified by the rectifying unit 110 and to calculate magnitude of the separated band in RMS (Root Mean Square) value. To be more specific, although not illustrated in FIG.4, the filter unit 120 includes a band pass filter (not shown) and an RMS calculator (not shown) to calculate magnitude of ripple voltage from the seperated frequency band. Particularly, the frequency may be in the range of 110Hz to 130Hz, details of which will be described later.

The input phase missing detecting unit 130 determines whether an input phase missing has occurred according to the magnitude of the ripple voltage which corresponds to RMS value of the frequency band filtered and calculated by the filter unit 120.

To be more specific, the input phase missing detecting unit 130 determines that the input phase missing has not occurred, in a case the magnitude of the ripple voltage is smaller than a predetermined value, and alternatively, determines that the input phase missing has occurred, in a case the magnitude of the ripple voltage is greater than a predetermined value.

As noted from the foregoing, whether an input phase missing has occurred can be determined by obtaining the magnitude of the ripple voltage and comparing the magnitude of the ripple voltage with a reference value.

FIG.5 is a circuit diagram illustrating an apparatus for detecting input phase missing according to an exemplary embodiment of the present disclosure.

As described, the power input unit 100 functions to input a 3-phase AC voltage and the rectifying unit 110 includes a plurality of diodes, and functions to rectify each of the 3-phase AC voltages (R, S, T) inputted from the power input unit 100.

Meanwhile, although not described in FIG.4, FIG.5 illustrates a smoothing capacitor 140 in addition to what is shown as being configured in FIG.4.

The smoothing capacitor 140 functions to convert the rectified output from the rectifying unit 110 into a smooth DC output voltage. Meanwhile, reference numeral 150 in FIG.5 illustrates a configuration of a condensed technical feature of the present disclosure, and refers to a controller including the filter unit and the input phase missing detecting unit of FIG.4. That is, the filter unit and the input phase missing detecting unit may be separately configured in the present disclosure, and may be configured as one unit that determines the input phase missing, which will be described as a controller 150 in FIG.5.

As noted from the above, the controller 150 calculates an RMS value by separating the rectified voltage by the rectifying unit 110 to a particular frequency band, i.e., from 110Hz to 130Hz, to know the magnitude of ripple voltage. The calculated magnitude of ripple voltage is compared with a predetermined value to display that an input phase missing has occurred, in a case the calculated magnitude of ripple voltage is greater than the predetermined value.

Meanwhile, the controller 150 may discontinue the operation of a PWM inverter 160 in a case the input phase missing has occurred.

Furthermore, although not illustrated in FIGS.4 and 5, a display unit (not shown) may be further included to the apparatus to allow a user to know that the image phase missing has occurred, in a case the image phase missing has occurred.

The display unit (not shown) may display whether the image phase missing has occurred by way of an audio signal or a visual signal. To be more specific, the display unit may display to a user whether the image phase missing has occurred by way of a speaker, and emit a light displaying to the user whether the image phase missing has occurred by way of an light emitting unit, where the light emitting unit may be an LED (Light Emitting Device). The user can intuitively recognize whether the image phase missing has occurred through the display unit and prevent a capacitor and/or an inverter from being damaged as well.

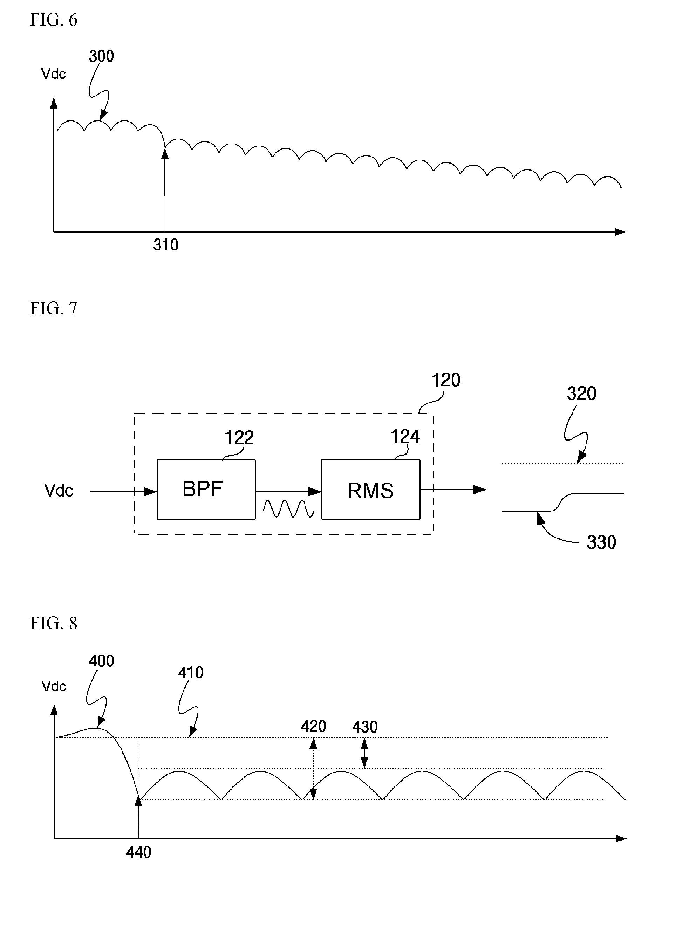

FIG.6 is a schematic view illustrating a problem unsolved by prior art, where reference numeral 300 is a converted DC current, and illustrates that the DC voltage has decreased at a point of reference numeral 310 when an inverter starts operation. In a case the prior art is used, a problem occurs that an input phase non-missing can be determined as being an input phase missing, even if there is an input phase non-missing case.

Meanwhile, FIG.7 is a schematic view illustrating an effect of an apparatus for detecting input phase missing according to an exemplary embodiment of the present disclosure.

A DC voltage (Vdc) converted by the rectifying unit 110 in FIG.7 passes the filter unit 120. To be more specific, the filter unit 120 includes a band pass filter and an RMS calculator to calculate magnitude of ripple voltage from the DC voltage in an RMS value. The input phase missing detecting unit 130 compares the calculated magnitude of ripple voltage 330 with the predetermined value 320.

In FIG.7, due to the fact that the predetermined value 320 is greater than the calculated magnitude of ripple voltage 330, that is, the calculated magnitude of ripple voltage 330 is smaller than the predetermined value 320, the input phase missing detecting unit 130 does not determine that the input phase missing has occurred. That is, the prior art problem illustrated in FIG.6 can be solved.

The band pass filter may be set to extract a frequency almost twice the commercial power frequency, that is, a frequency component in the range of 110Hz to 130Hz in case of using 60Hz commercial power frequency.

Furthermore, a sampling frequency of the band pass filter may be a sampling frequency more than twice the frequency, that is, 120Hz which is a frequency processed by the band pass filter to allow the band pass filter to operate free from anti-aliasing phenomenon. In other words, in case of using the commercial power of 60Hz, the band pass filter may use a sampling frequency of at least more than 240Hz.

FIG. 8 is a schematic view illustrating a method for detecting an input phase missing by processing a DC voltage, by an apparatus for detecting input phase missing according to an exemplary embodiment of the present disclosure, where reference numeral 400 shows a DC voltage and where a 120Hz component is prevalent when an input phase missing has occurred. An operation started at a point of reference numeral 440, where a DC voltage shows a ripple of 120Hz.

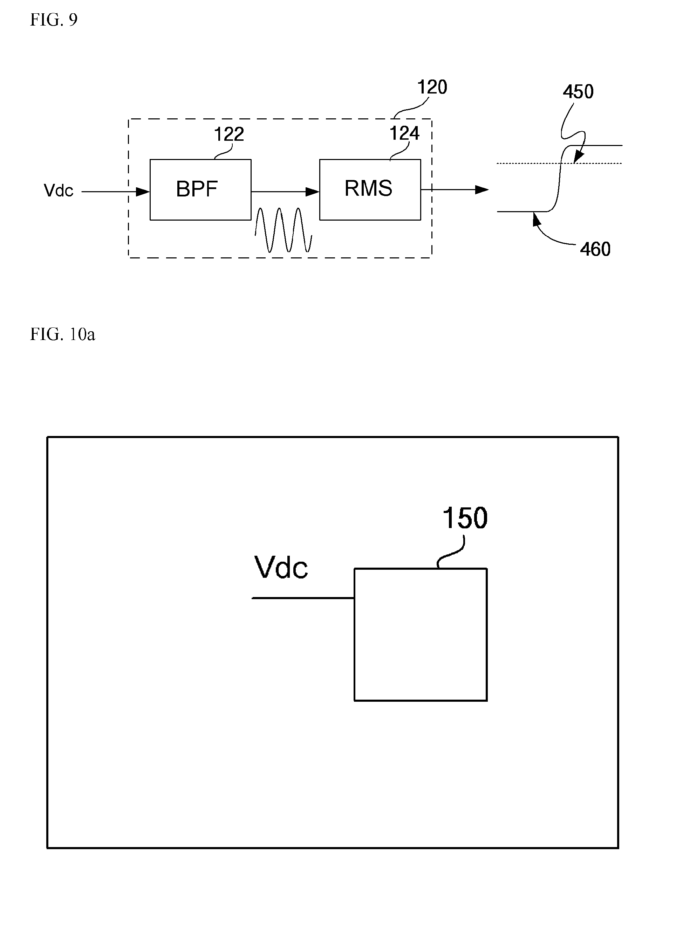

FIG.9 is a schematic view a method for detecting an input phase missing by processing the DC voltage of FIG.8, by an apparatus for detecting input phase missing according to an exemplary embodiment of the present disclosure. Unlike FIG.7, magnitude of signal in FIG.9 having passed the band pass filter 122 is large to generate a signal as that of reference numeral 460 after passing an RMS calculator 124. That is, the input phase missing detecting unit determines that the input phase missing has occurred because the calculated magnitude of ripple voltage 460 is greater than the predetermined value 450.

The band pass filter in FIGS. 7, 8 and 9 formed at the apparatus for detecting an input phase missing according to an exemplary embodiment of the present disclosure is preferred to extract only the frequency of 120Hz band. In this case, magnitude of ripple voltage can be known without any separate calculation of frequency band to more swiftly determine whether the input phase missing has occurred.

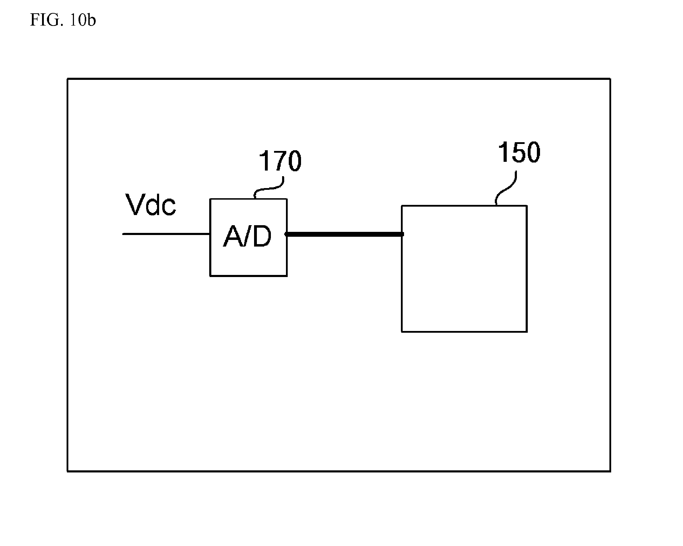

FIGS.10a and 10b are schematic views illustrating a variety of examples applicable by an apparatus for detecting input phase missing according to an exemplary embodiment of the present disclosure, where FIG.10a illustrates a case of an Analogue-to-Digital converter being formed inside a CPU, while FIG.10b illustrates a board having an Analogue-to-Digital converter 170. The apparatus for detecting an input phase missing according to an exemplary embodiment of the present disclosure may be applied either to any board of FIG.10a or FIG. 10b.

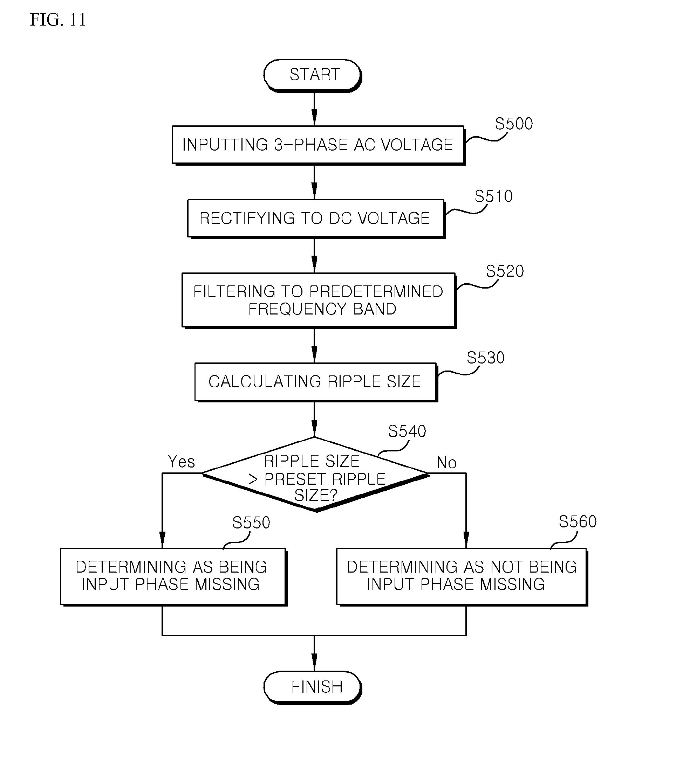

Lastly, a method for detecting an input phase missing according to an exemplary embodiment of the present disclosure will be described with reference to FIG.11. FIG.11 is a flowchart illustrating a method for detecting an input phase missing according to an exemplary embodiment of the present disclosure.

First, a 3-phase AC voltage is inputted S500. Next, the inputted voltage is rectified to a DC voltage S510. The rectified DC voltage is filtered to a predetermined frequency band S520. At this time, the predetermined frequency is preferably 120Hz but a frequency band of 110Hz to 130Hz may be also used. A ripple size (magnitude of ripple voltage) of the filtered voltage is calculated S530, and the calculated ripple size may be converted in an RMS value.

In a case the calculated ripple size is greater than the predetermined ripple size S540-YES, which is then determined as an input phase missing S550, and in a case the calculated ripple size is smaller than the predetermined ripple size S540-NO, it is then determined as an input phase non-missing S560.

Although FIG.11 has proposed various steps, it is to effectively explain only a process of determining whether there has occurred an input phase missing based on a ripple size, which is one of the important features according to the present disclosure. Thus, it should be apparent to those skilled in the art that a step of stopping operation of a PWM inverter driving a motor or a step of displaying to a user whether the input phase missing has occurred may be further included to the present disclosure.

Although the present disclosure has been described with reference to a number of illustrative embodiments thereof, it should be understood that numerous other modifications and embodiments can be devised by those skilled in the art that will fall within the spirit and scope of the principles of this disclosure.

More particularly, various variations and modifications are possible in the component parts and/or arrangements of subject combination arrangement within the scope of the disclosure, the drawings and the appended claims. In addition to variations and modifications in the component parts and/or arrangements, alternative uses will also be apparent to those skilled in the art.

## Claims

1. An apparatus for detecting an input phase missing based on a voltage inputted to a 3-phase inverter, the apparatus comprising: a power input unit applying a 3-phase AC voltage; a rectifying unit rectifying the AC voltage applied from the power input unit; a filter unit bandpass-filtering the rectified voltage and calculating magnitude of ripple voltage from the filtered voltage; and a missing input phase detecting unit determining whether an input phase missing has occurred according to the magnitude of the ripple voltage.

2. The apparatus of claim 1, wherein the filter unit includes a band-pass filter extracting a predetermined frequency band from the rectified voltage, and an RMS (Root Mean Square) calculation unit converting the magnitude of the extracted frequency band to a RMS value.

3. The apparatus of claim 2, wherein the band-pass filter extracts a frequency component from 110Hz to 130Hz, in a case a commercial power source of 60Hz is used.

4. The apparatus of claim 2 or 3, wherein a sampling frequency of the band-pass filter is at least 240Hz, in a case a commercial power source of 60Hz is used.

5. The apparatus of one of claims 1 to 4, further comprising a display unit for displaying whether an input phase missing has occurred.

6. A method for detecting an input phase missing based on a voltage inputted to a 3-phase inverter, the method comprising: applying a 3-phase AC voltage; rectifying the AC voltage; bandpass-filtering the rectified voltage; calculating magnitude of ripple voltage from the filtered voltage; and determining that an input phase missing has occurred according to the magnitude of the ripple voltage

7. The method of claim 6, wherein the filtering step includes extracting a predetermined frequency band from the rectified voltage, and converting the magnitude of the extracted frequency band to a RMS (Root Mean Square) value.

8. The method of claim 6 or 7, further comprising displaying whether an input phase missing has occurred.

9. The method of one of claims 6 to 8, further comprising discontinuing operation of a PWM (Pulse Width Modulation) inverter operating a motor, in a case it is determined by the determining step that the input phase missing has occurred.
